Europäisches Patentamt

European Patent Office

Office européen des brevets

(11) Publication number: **0 294 966 B1**

## EUROPEAN PATENT SPECIFICATION

(45) Date of publication of patent specification: **06.05.92**   (51) Int. Cl.⁵: **B23K 3/04**, H01R 43/02

(21) Application number: **88304674.0**

(22) Date of filing: **24.05.88**

(54) **Autoregulating multi contact heater.**

(30) Priority: **08.06.87 US 59767**

(43) Date of publication of application:
**14.12.88 Bulletin 88/50**

(45) Publication of the grant of the patent:
**06.05.92 Bulletin 92/19**

(84) Designated Contracting States:
**AT BE CH DE FR GB IT LI NL SE**

(56) References cited:
**DE-C- 728 661**
**US-A- 4 256 945**

**ELECTRONIC DESIGN, vol. 33, no. 26, 14th November 1985, pages 57,58, Hasbrouck Heights, New Jersey, US; V. BIANCOMANO: "Meeting high specifications, dense connectors march to the beat of surface mounting"**

(73) Proprietor: **METCAL INC.**
**3704 Haven Court**
**Menlo Park California 94025(US)**

(72) Inventor: **Doljack, Frank A. 3181 Candon Court Pleasanton**
**California 94566(US)**

(74) Representative: **Hayward, Denis Edward Peter et al**
**Lloyd Wise, Tregear & Co. Norman House**
**105-109 Strand**
**London WC2R 0AE(GB)**

## Description

The present invention relates to the soldering of complex structures such as multipin electrical connectors by means of autoregulating Curie point heating.

The application of autoregulating Curie point heaters, such as disclosed in U.S. Patent No. 4,256,945, to the soldering of multipin surface mounted connectors has proved to be a difficult task. Where single contact connectors are encountered, a heater such as a soldering iron may be employed. The soldering of multiple contact connections on non-complex shapes has been proposed in EPA-0206619.

However, attempts at soldering complex-shaped surface mounted devices employing inductive coupling to a Curie point heater have encountered flux leakage problems which have rendered these approaches inefficient, resulting in excessive Joule heating and potential damage to adjacent delicate electronic components.

According to the present invention, there is provided an arrangement for soldering a multipin connector to a support that bears a plurality of conductors,

comprising a multipin connector having a plurality of contacts spaced along it,

each multipin connector contact including a ferromagnetic material having a Curie temperature above the melting point of a fusible material employed to solder the contact to a conductor on said support, and

electromagnetic energiser means for inducing an alternating electric current in each multipin connector contact to generate Joule heat sufficient to raise the ferromagnetic material to its effective Curie temperature thereby to achieve autoregulating heating to melt the fusible material,

said energiser means including

a core of a high electrical impedance, high permeability material with opposed poles defining an air gap and having an alternating current energising coil to establish magnetic flux across the gap, each pole having a plurality of spaced pole pieces each paired with a respective one of the opposed pole pieces on the other pole with the spacing along the air gap between successive pairs of opposed pole pieces corresponding to the spacings of the multipin connector contacts along the multipin connector and the widths across the gap between the opposed pole pieces of the pairs of poles being such that the presence of the multipin connector contacts in the gap in alignment with respective pairs of opposed pole pieces substantially completes the flux paths between the opposed pole pieces.

The invention further provides a method for soldering contacts of a multipin connector to electrical conductors on a support, comprising providing on each multipin connector contact a ferromagnetic material with an effective Curie temperature above the melting point of a fusible material employed to solder each contact to a conductor on said support, positioning the multipin connector on the support, placing the contacts of the multipin connector, while in position on the support, within the air gap between poles on a core of an electromagnetic energiser having an a.c. energising coil, and energising the coil thereby to induce an a.c. current in each contact sufficient to raise the ferromagnetic material to its effective Curie temperature and achieve autoregulating heating to melt the fusible material, the poles of the core being configured to provide a row of spaced pole pieces on one pole and a corresponding row of opposed pole pieces on the other pole with the spacings, in the direction along the rows, between successive pairs of opposed pole pieces matching the spacings of the contacts along the connector and the air gap width between the two pole pieces of each opposed pair being selected such that the presence of the contacts in the air gap in alignment with the pole pieces substantially completes the flux paths between the opposed pole pieces.

Preferably, the core of the energiser has a conductivity less than $10^{-8}$ ohm-cms.

In the preferred embodiment, a coil wound core of high resistance, low loss magnetic material has multiple, shaped pole pieces to concentrate flux in ferromagnetic material forming part of each contact pin of a multipin connector whereby each pin is efficiently heated to a temperature approaching its Curie temperature at which temperature autoregulation becomes effective.

The core material may be powdered iron or a ferrite having resistivities as high as $10^9$ ohm-cms and having low hysteresis losses. Ferrites cover a wide range of Curie temperatures; 120°C. - 500°C. and permeabilities; 20-5000. Powdered iron cores have very high Curie temperatures. By using such materials the eddy current and hysteresis losses and thus core losses are quite low. The arrangement permits the high flux density of the core to be transferred to the ferromagnetic material of the contacts further increasing efficiency and thus good autoregulation.

The core may take the general form of a rectangle having one side interrupted to provide opposed poles. The poles are then intended to be disposed on opposite sides of a multipin connector the contacts of which have a ferromagnetic covering whereby each contact pin becomes a self-regulating heater.

The core may thus be shaped to closely accommodate a connector in its air gap, the connector having an array of spaced contacts or contact groups and the poles of the core having an opposed pair of shaped pole pieces for each contact or contact group of the array whereby each pole piece pair concentrates flux into its respective juxtaposed contact or contact group. Curved, straight, wavy and irregular contact arrays can be accommodated by providing similarly configured rows of corresponding pole pieces.

Arrangements in accordance with the invention will now be described by way of example and with reference to the accompanying drawings in which:

Figure 1 is a top view of a multipin connector;

Figure 2 is a side view of a multipin connector;

Figure 3 is a side view of a core with a multipin connector in its air gap;

Figure 4 is a top view of a core with a multipin connector in its air gap; and

Figures 5A, 5B and 5C illustrate different configurations of pole piece arrays on the core.

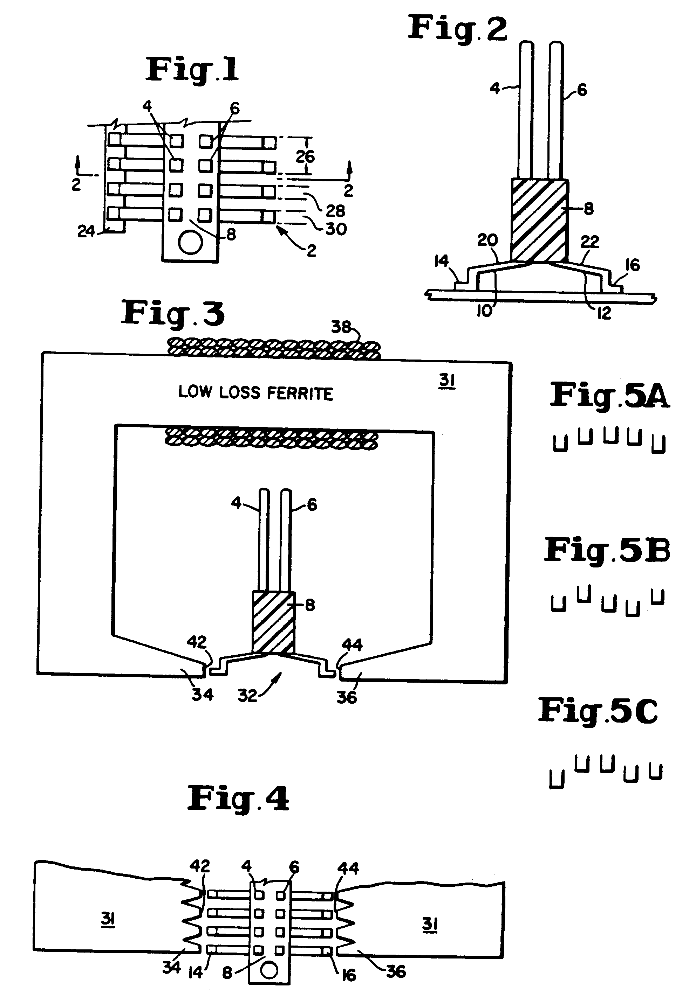

Referring now to Figures 1 and 2 of the accompanying drawings, there is illustrated a multipin connector 2 to be secured to a circuit board or the like. The connector comprises a plurality of upstanding pins 4 and 6 arranged in pairs and secured in a base 8 of the insulating material. The pins 4 and 6 terminate below the base 8 in outwardly extending conductive legs 10 and 12, respectively having feet 14 and 16 intended to contact, for instance, a printed circuit board 18. As can be seen in the example of the multipin connector of Figure 1, a connector may have two rows of pins of indefinite numbers each, eight being illustrated in two rows of four each.

The legs 10 and 12 have coverings 20 and 22 respectively, on all surfaces except the contact surface, of ferromagnetic material which has an effective Curie temperature sufficient to melt solder or the like. The connector is to have each foot soldered to a different printed circuit lead or in some instances two or more to the same lead. As an example, the left feet of Figure 1 are all secured to a lead 24, the upper two feet on the right side are to be connected to a lead 26 and the lower two right side feet are to be connected to separate leads 28 and 30.

Referring now to Figures 3 and 4, there is provided a heater energiser circuit comprising a high impedance generally rectangular core 31 having a gap 32 lying between poles 34 and 36 of the core. The core has a winding 38 disposed about a side 40 opposite gap 32. The core is elongated perpendicular to the plane of the core, i.e. the plane of the page as illustrated in Figure 3. Each pole is provided with a row of triangular slots or recesses to define a row of shaped pole pieces 42 on one side of the gap and a row of pole pieces 44 on the other side of the gap. Each of the pole pieces 42 is aligned with a respective pole piece 44 on the other side of the gap so that a direct flux path is established between each pair of opposed pole pieces.

When in use, the core 31 is positioned with each pair of opposed pole pieces having located therebetween opposed feet 14 and 16 of a pair of the pins 4 and 6 of the multipin connector 2 of Figures 1 and 2. The magnetic materials 20 and 22 covering the legs of the pins complete the magnetic path across the gap whereby a path of low reluctance is established. Upon energisation of coil 38 with a constant alternating current, the magnetic materials 20 and 22 are heated to a temperature approaching their Curie temperatures. When the temperature has risen sufficiently, the materials 20 and 22 become paramagnetic and since the current is constant and the available current now spreads into the low resistance material of the legs 10 and 12, which is copper for instance, the heating is marginally reduced, the temperature of the member falls, and the members 20 and 22 become magnetic again, so that the cycle is repeated and autoregulation results.

The pole pieces 42 and 44 are shaped so as to concentrate flux in the magnetic layers 20 and 22 and are located very close to and in some instances in contact with the layers 20 and 22 to minimise the magnetic reluctance of the path. Also in multipin connectors of the type under consideration the gap between the legs 10 and 12 is quite small further contributing to a low reluctance magnetic path.

The array of pole pieces does not have to be a straight row and the pole pieces do not have to be rectangular in cross section. A curved or even wavy or irregular array of pole pieces is permitted all as illustrated in Figures 5A, 5B and 5C. Also the pole pieces can be cylindrical to avoid sharp corners that induce leakage flux. It should be noted that the current supplied relative to the minimum cross-sectional area of the magnetic path should be such that saturation does not occur along the magnetic path. Saturation, it must be realised, greatly increases leakage flux and contributes to inefficient operation and in the presence of sensitive components can destroy a chip or the like.

The material of the core is preferably a powdered iron or a ferrite. One appropriate ferrite is available from Fair Rite Products as Product No. 861103001. This material is a ferric oxide mixed with other oxides, has a mu of approximately 125 and a conductivity of approximately $10^{-9}$ ohm-cms.

The term "constant current" as employed herein does not mean a current that cannot increase, but means a current that obeys the following formula

$$\frac{\Delta |I|}{|I|} \quad > - \tfrac{1}{2} \quad \frac{\Delta R}{R}$$

where I is the load current. Specifically, in order to autoregulate, the power delivered to the load when the heater exceeds Curie temperature, must be less than the power delivered to the load below Curie temperature. If the current is held invariable, then the best autoregulating ratio is achieved, short of controlling the power supply to reduce current. So long, however, as the current is controlled in accordance with the above formula, autoregulation is achieved. Thus, when large self regulating ratios are not required, constraints on the degree of current control may be relaxed thus reducing the cost of the power supply.

The above equation is derived by analysing the equation:

$$P = [I^2 R]$$

where P is power and I is the current in the load. Differentiating with respect to R

$$\frac{dP}{dR} = |I|^2 + 2R|I|\frac{dI}{dR}$$

to satisfy the requirements for self regulation dP/dR>O. Thus,

$$|I^2| \quad + \quad 2R|I| \quad \frac{d|I|}{dR} \quad > \quad 0$$

which reduces to the above equation. It should be noted, however, that the more constant the current the better the self regulation.

## Claims

1.  An arrangement for soldering a multipin connector (2) to a support (18) that bears a plurality of conductors,

    comprising a multipin connector (22) having a plurality of contacts (10,12) spaced along it,

    each multipin connector contact including a ferromagnetic material (20,22) having a Curie temperature above the melting point of a fusible material employed to solder the contact to a conductor on said support, and

electromagnetic energiser means for inducing an alternating electric current in each multipin connector contact to generate Joule heat sufficient to raise the ferromagnetic material to its effective Curie temperature thereby to achieve autoregulating heating to melt the fusible material,

said energiser means including

a core (31) of a high electrical impedance, high permeability material with opposed poles (34,36) defining an air gap (32) and having an alternating current energising coil (38) to establish magnetic flux across the gap, each pole having a plurality of spaced pole pieces (42) each paired with a respective one of the opposed pole pieces (44) on the other pole with the spacing along the air gap (32) between successive pairs of opposed pole pieces (42,44) corresponding to the spacings of the multipin connector contacts (10,12) along the multipin connector (2) and the widths across the gap (32) between the opposed pole pieces (42,44) of the pair of poles (34,36) being such that the presence of the multipin connector contacts (10,12) in the gap (32) in alignment with respective pairs of opposed pole pieces (42,44) substantially completes the flux paths between the opposed pole pieces (42,44).

2.  An arrangement according to Claim 1, wherein said core (31) is of a ferrite material.

3.  An arrangement according to Claim 1 or Claim 2, wherein said core (31) is of a low hysteresis loss material and has a conductivity of less than $10^{-8}$ ohm-cms.

4.  An arrangement according to any preceding claim, wherein said coil (38) is connected to a constant current a.c. source.

5.  An arrangement according to any preceding claim, wherein the pole pieces (42,44) on each pole (34,36) are arranged in a straight row.

6.  An arrangement according to any one of Claims 1 to 4, wherein the pole pieces on each pole are arranged in a row of curved or wavy or irregular configuration.

7.  A method for soldering contacts of a multipin connector (2) to electrical conductors (24,26,28,30) on a support (18), comprising providing on each multipin connector contact (10,12) a ferromagnetic material (20,22) with an effective Curie temperature above the melting point of a fusible material employed to solder each contact (10,12) to a conductor (24,26,28,30) on said support (18), positioning the multipin connector (2) on the support (18), placing the contacts (10,12) of the multipin connector, while in position on the support (18), within the air gap (32) between poles (34,36) on a core (31) of an electromagnetic energiser having an a.c. energising coil (38), and energising the coil thereby to induce an a.c. current in each contact (10,12) sufficient to raise the ferromagnetic material (20,22) to its effective Curie temperature and achieve autoregulating heating to melt the fusible material, the poles (34,36) of the core (31) being configured to provide a row of spaced pole pieces (42) on one pole (34) and a corresponding row of opposed pole pieces (44) on the other pole (36) with the spacings, in the direction along the rows, between successive pairs of opposed pole pieces (42,44) matching the spacings of the contacts (10,12) along the connector (22) and the air gap width between the two pole pieces (42,44) of each opposed pair being selected such that the presence of the contacts (10,12) in the air gap (32) in alignment with the pole pieces (42,44) substantially completes the flux paths between the opposed pole pieces.

**Revendications**

1.  Agencement de soudage d'un connecteur multibroche (2), à un support (18) qui porte une pluralité de conducteurs,
    comportant un connecteur multibroche (22) ayant une pluralité de contacts (10,12) espacés sur sa longueur,
    chaque connecteur multibroche comportant un matériau ferromagnétique (20,22) ayant une température de Curie au-dessus du point de fusion d'un matériau fusible utilisé pour souder le contact au conducteur sur ledit support, et
    des moyens de magnétisation pour induire un courant électrique alternatif dans chaque contact du connecteur multibroche pour générer un réchauffement par effet joule suffisant pour élever le matériau ferromagnétique à sa température de Curie effective, obtenant ainsi un chauffage autorégulant pour fondre le matériau fusible,
    lesdits moyens de magnétisation incluant
    un noyau (31) en un matériau d'impédance électrique et de perméabilité élevées, ayant des pôles opposés (34,36) définissant un entrefer (32) et ayant un enroulement (38) produisant un courant alternatif pour établir un flux magnétique à travers l'entrefer, chaque pôle ayant une pluralité de portions de pôle espacées (42), chacune étant appariée avec l'une des portions de pôle correspondantes opposées (42,44), les espacements le long de l'entrefer (32) entre les paires successives de portions de pôle opposées (42,44) correspondant aux espacements entre les contacts du connecteur multibroche (10,12) le long du connecteur multibroche (2) et les largeurs d'entrefer (32) entre les portions de pôle opposées (42,44) des paires de pôles (34,36) étant telles que la présence des contacts (10,12) du connecteur multibroche dans l'entrefer (32), en alignement avec les paires respectives de portions de pôle opposées (42,44) complètent substantiellement les passages de flux entre les portions de pôle opposées.

2.  Agencement selon la revendication 1, dans lequel ledit noyau (31) est en un matériau en ferrite.

3.  Agencement selon la revendication 1 ou 2, dans lequel ledit noyau (31) est en un matériau à faibles pertes d'hystérésis et ayant une conductivité inférieure à $10^{-8}$ Ohm.cm.

4.  Agencement selon l'une quelconque des revendications précédentes, dans lequel ledit enroulement (38) est relié à une source de courant alternatif constant.

5.  Agencement selon l'une quelconque des revendications précédentes, dans lequel les portions de pôle (42,44) sur chaque pôle (34,36) sont disposées en une rangée droite.

6.  Agencement selon l'une quelconque des revendications 1 à 4, dans lequel les portions de pôle sur chaque pôle sont disposées sur une rangée de forme incurvée ou ondulée ou irrégulière.

7.  Procédé de soudage des contacts d'un connecteur multibroche (2), à des conducteurs électriques (24,26,28,30) sur un support (18), consistant à apporter sur chaque contact (10,12) de connecteur multibroche un matériau ferromagnétique (20,22) avec une température de Curie effective supérieure au point de fusion d'une matière fusible utilisée pour souder chaque contact (10,12) à un conducteur (24,26,28,30) sur ledit support (18), à positionner le connecteur multibroche (2) sur ledit support (18), à placer les contacts '10,12) du connecteur multibroche, tant qu'ils sont positionner sur le support (18), dans l'entrefer (32) entre les pôles (34,36) sur un noyau (31) d'un excitateur électromagnétique ayant une bobine de magnétisation (38) à courant alternatif, et à magnétiser ce faisant la bobine pour induire un courant alternatif dans chaque contact (10,12), suffisant pour élever le matériau ferromagnétique (20,22) à sa température de Curie effective et obtenir le chauffage d'autorégulation pour fondre la matière fusible, les pôles (34,36) du noyau (31) étant configurés pour fournir une rangée de portions de pôles (42) espacées sur un pôle (34) et une rangée correspondante de portions de pôle (44) opposées sur l'autre pôle (36), les espacements, dans la direction longeant la rangée, entre des paires successives de portions de pôles opposées (42,44) correspondant aux espacements des contacts (10,12) le long du connecteur (22), la largeur de l'entrefer entre deux portions de pôle (42,44) de chaque paire opposée étant choisie de telle façon que la présence des contacts (16,12) dans l'entrefer (32) en alignement avec les portions de pôle (42,44) complète le passage de flux entre les portions de pôle opposées.

**Patentansprüche**

1. Anordnung zum Verlöten eines mehrstiftigen Verbinders (2) mit einem Träger (18), der mehrere Leiter trägt`

    mit einem mehrstiftigen verbinder (22) mit einer Anzahl von über seine Länge im Abstand angeordneten Kontakten (10, 12),

    wobei jeder Kontakt des mehrstiftigen Verbinders ein ferromagnetisches Material (20, 22) aufweist, das eine Curie-Temperatur oberhalb des Schmelzpunktes eines schmelzbaren Materials hat, das zur Verlötung des Kontaktes mit einem Leiter auf dem Träger verwendet ist, und

    mit elektromagnetischen Energieversorgungsmitteln zur Induzierung eines elektrischen Wechselstromes in jedem Kontakt des mehrstiftigen Verbinders, um ausreichend Joule'sche Wärme zu erzeugen, die ausreicht, um das ferromagnetische Material auf seine effektive Curie-Temperatur anzuheben, um dadurch selbstregulierende Erwärmung zu erzielen, um das schmelzbare Material zu schmelzen,

    wobei die Energieversorgungsmittel aufweisen

    einen Kern (31), der aus einem Material hoher elektrischer Impedanz und hoher Permeabilität besteht, zwei einen Luftspalt (32) definierende Pole (34, 36) und eine Spule (38) für Speisewechselstrom, um einen magnetischen Fluß über den Luftspalt zu erzeugen, wobei jeder Pol eine Anzahl von im Abstand angeordneten Polstücken (42) aufweist, die jeweils paarig einem entsprechenden der gegenüberliegenden Polstücke (44) auf dem anderen Pol zugeordnet sind, wobei der Abstand entlang dem Luftspalt (32) zwischen aufeinanderfolgenden Paaren von gegenüberliegenden Polslücken (42, 44), den Abständen der Kontakte (10, 12) entlang dem mehrstiftigen Verbinder (2) entspricht und die Breite über den Spalt (32) zwischen den gegenüberliegenden Polstücken (42, 44) des Paares von Polen (34, 36 so ist, daß die Anwesenheit der Kontakte (10, 12) des mehrstiftigen Verbinders in dem Spalt (32), ausgerichtet zu zugehörigen Paaren gegenüberliegender Polstücke (42, 44) im wesentlichen die Flußpfade zwischen den gegenüberliegenden Pulstücken (42, 44) vervollständigt.

2. Anordnung nach Anspruch 1, **dadurch gekennzeichnet,** daß der Kern (31) aus Ferritmaterial besteht.

3. Anordnung nach Anspruch 1 oder 2, **dadurch gekennzeichnet,** daß der Kern (31) aus einem Material niedriger Hystereseverluste und mit einer spezifischen Leitfähigkeit von weniger als $10^{-8}$ Ohm/cm besteht.

4. Anordnung nach einem der vorhergehenden Ansprüche, **dadurch gekennzeichnet,** daß die Spule (38) an eine Konstantwechselstromquelle angeschlossen ist.

5. Anordnung nach einem der vorhergehenden Ansprüche, **dadurch gekennzeichnet,** daß die Polstücke (42, 44) auf jedem Pol (34, 36) in einer geraden Reihe angeordnet sind.

6. Anordnung nach einem der Ansprüche 1 bis 4, **dadurch gekennzeichnet,** daß die Polstücke auf jedem Pol in einer Reihe bogenförmiger oder wellenförmiger oder unregelmäßiger Konfiguration angeordnet sind.

7. Verfahren zum Verlöten von Kontakten eines mehrstiftigen verbinders (2) mit elektrischen Kontakten (24, 26, 28, 30) auf einem Träger (18), gekennzeichnet durch Aufbringen eines ferromagnetischen Materials (20, 22) mit einer effektiven Curie-Temperatur, die oberhalb des Schmelzpunktes eines schmelzbaren Materials liegt, das zum Verlöten jedes Kontaktes (10, 12) mit einem Leiter (24, 26, 28, 30) auf dem genannten Träger (18) verwendet wird, auf Jeden Kontakt (10, 12) des mehrstiftigen Verbinders, Positionieren des mehrstiftigen Verbinders (2) auf dem Träger (18), Einbringen der Kontakte (10, 12) des mehrstiftigen Verbinders, während sie sich in ihrer Lage auf dem Träger (18) befinden, in den Luftspalt (32) zwischen Polen (34, 36) auf einem Kern (31) einer elektromagnetischen Speiseeinrichtung, die eine Spule (38) zur Wechselstromspeisung aufweist, und Speisen der Spule, um so einen wechselstrom in jedem Kontakt (10, 12) zu induzieren, der ausreicht, um das ferromagnetische Material (20, 22) auf seine effektive Curie-Temperatur anzuheben und selbstregulierende Erwärmung zu erzielen, um das schmelzbare Material zu erwärmen, wobei die Pole (34, 36) des Kerns (31) so angeordnet sind, daß sie eine Reihe beabstandeter Polstükke (42) auf einem Pol (34) bilden und eine entsprechende Reihe von gegenüberliegenden Polstücken (44) auf dem anderen Pol (36), wobei die Abstände in Richtung entlang den Reihen zwischen aufeinanderfolgenden Paaren Von gegenüberliegenden Polstücken (42, 44) mit den Abständen der Kontakte (10, 12) entlang dem Verbinder (22) übereinstimmen und die Breite des Luftspaltes zwischen den beiden polstücken (42, 44) jedes gegenüberliegenden Paares so ausgewählt ist, daß die Anwesenheit der Kontakte (10, 12) in dem Luftspalt (32) bei Ausrichtung mit den Polstücken (42, 44) im wesentlichen die Flußpfade zwischen den gegenüberliegenden Polstücken vervollständigen.

# Fig.1

# Fig.2

# Fig.3

LOW LOSS FERRITE

31

# Fig.5A

⊔ ⊔ ⊔ ⊔ ⊔

# Fig.5B

⊔ ⊔ ⊔ ⊔ ⊔

# Fig.5C

⊔ ⊔ ⊔ ⊔ ⊔

# Fig.4

31                    31

8